# EUROPEAN PATENT SPECIFICATION

(11) **EP 4 175 446 B1**
(45) Date of publication and mention of the grant of the patent: **24.12.2025**
(21) Application number: 22204534.6
(22) Date of filing: 28.10.2022
(51) Int. Cl.: H10K 59/38

(54) **DISPLAY PANEL**
ANZEIGETAFEL
PANNEAU D'AFFICHAGE

(30) Priority: 29.10.2021 KR 20210146781
(43) Date of publication of application: 03.05.2023
(73) Proprietor: Samsung Display Co., Ltd., Yongin-si, Gyeonggi-do 17113 (KR)
(72) Inventor: LEE, Gak Seok, Hwaseong-si (KR); KIM, Inok, Osan-si (KR); OH, Keunchan, Hwaseong-si (KR); LEE, Sanghun, Hwaseong-si (KR); LEE, Soyun, Seoul (KR); JANG, Jieun, Suwon-si (KR); JANG, Chang-Soon, Seoul (KR)
(74) Representative: Walaski, Jan Filip

(56) References cited:
- US-A1- 2018 188 593
- US-A1- 2020 227 485
- US-A1- 2021 335 893

## Description

### CROSS-REFERENCE TO RELATED APPLICATION

The present application claims priority to Korean Patent Application No. 10-2021-0146781, filed on October 29, 2021.

### BACKGROUND

### 1. Field

Aspects of some embodiments of the present disclosure relate to a display panel.

### 2. Description of the Related Art

A display device may include a wavelength (or colour) conversion member to display colours. The wavelength conversion member includes pigment particles having a set or predetermined colour or a light emitting material emitting a light having a set or predetermined colour. When light provided from a pixel area is provided to a wavelength converter adjacent thereto, the wavelength converter adjacent to the pixel area as well as a wavelength converter corresponding to the pixel area emits the light, and as a result, colours of light may be mixed with each other. US 2020/227485 A1 discloses a display panel with colour conversion patterns to convert light of a first colour into light of second and third colours.

The above information disclosed in this Background section is only for enhancement of understanding of the background and therefore the information discussed in this Background section does not necessarily constitute prior art.

### SUMMARY

Aspects of some embodiments of the present disclosure relate to a display panel. For example, aspects of some embodiments of the present disclosure relate to a display panel with relatively improved image quality.

Aspects of some embodiments of the present disclosure include a display panel with relatively improved display quality by preventing, reducing, or controlling instances or degree of mixing of the colours of lights.

According to the invention, there is provided a display panel according to claim 1. Preferred features are set out in the dependent claims.

According to the above, as the colour conversion patterns are spaced apart from each other at different intervals, the mixture of colours of lights may be prevented, reduced, or controlled, and thus, a display quality of the display panel may be relatively improved.

### BRIEF DESCRIPTION OF THE DRAWINGS

The above and other aspects and characteristics of embodiments according to the present disclosure will become more readily apparent by reference to the following detailed description when considered in conjunction with the accompanying drawings wherein:
FIG. 1A is a perspective view of a display panel according to some embodiments of the present disclosure;
FIG. 1B is a cross-sectional view of a display panel according to some embodiments of the present disclosure;
FIG. 1C is a plan view of a display panel according to some embodiments of the present disclosure;
FIG. 2 is an enlarged plan view of a display panel according to some embodiments of the present disclosure;
FIG. 3 is a cross-sectional view of a display panel according to some embodiments of the present disclosure;
FIG. 4 is a cross-sectional view of a portion of a display panel according to some embodiments of the present disclosure;
FIGS. 5A to 5C are enlarged plan views of a display panel according to some embodiments of the present disclosure; and
FIG. 6 is a graph showing an effect according to some embodiments of the present disclosure.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" includes any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another element(s) or feature(s) as illustrated in the figures.

It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, aspects of some embodiments of the present disclosure will be described in more detail with reference to accompanying drawings.

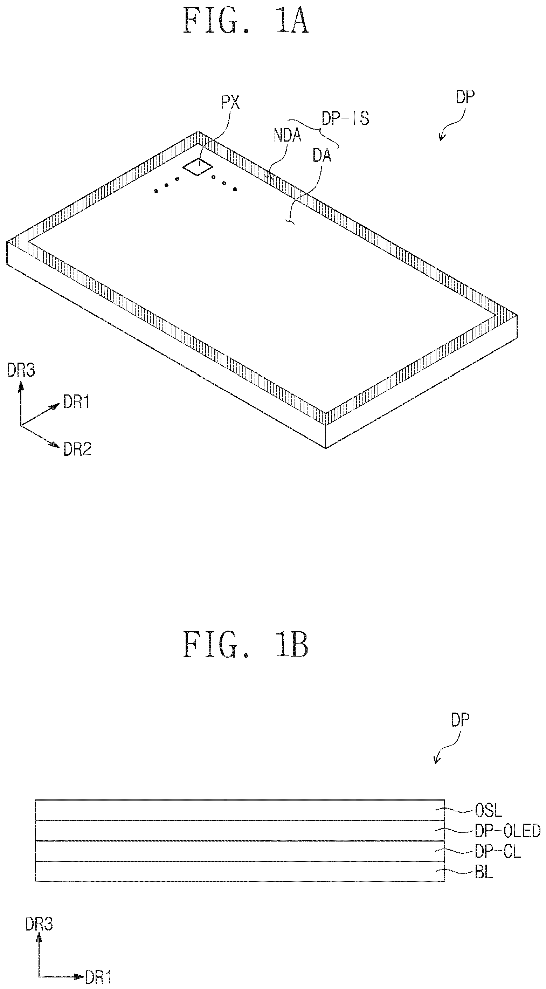

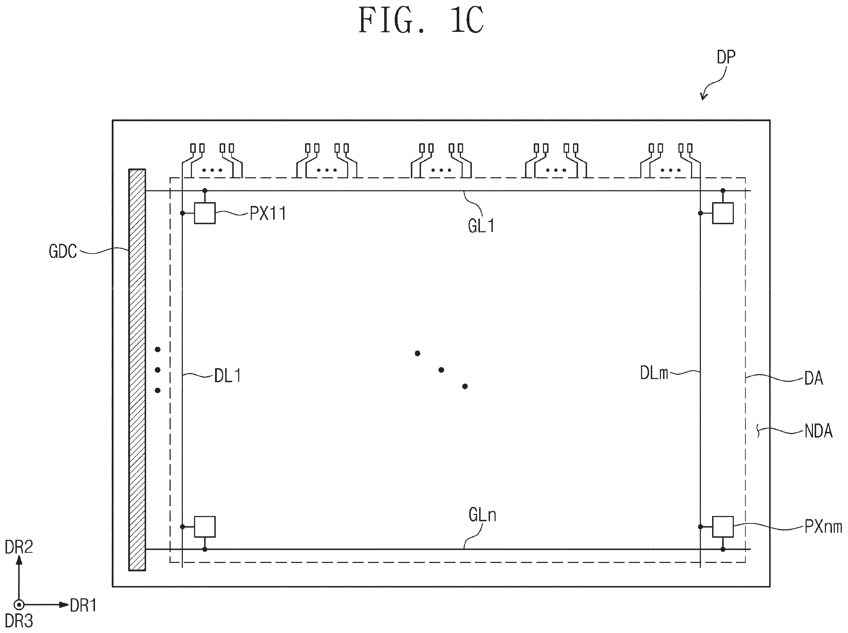

FIG. 1A is a perspective view of a display panel DP according to some embodiments of the present disclosure. FIG. 1B is a cross-sectional view of the display panel DP according to some embodiments of the present disclosure. FIG. 1C is a plan view of the display panel DP according to some embodiments of the present disclosure.

Referring to FIG. 1A, the display panel DP may display images at a display surface DP-IS. The display surface DP-IS may be parallel (or substantially parallel) to a plane defined by a first directional axis DR1 and a second directional axis DR2. The display surface DP-IS may include a display area DA and a non-display area NDA. A plurality of pixels PX (which may be referred to hereinafter as "a pixel PX") may be located in the display area DA and may not be located in the non-display area NDA. The non-display area NDA may be defined along an edge (e.g., in a periphery, or outside a footprint) of the display surface DP-IS. The non-display area NDA may surround the display area DA. According to some embodiments, the non-display area may be omitted or may be located at only one side of the display area DA.

A third directional axis DR3 may indicate a normal line direction of the display surface DP-IS, i.e., a thickness direction of the display panel DP. Front (or upper) and rear (or lower) surfaces of each layer or each unit are distinguished from each other by the third directional axis DR3. However, the first, second, and third directional axes DR1, DR2, and DR3 described with respect to the present embodiments are merely examples. Hereinafter, first, second, and third directions are defined as directions respectively indicated by the first, second, and third directional axes DR1, DR2, and DR3 and are assigned with the same reference numerals as the first, second, and third directional axes DR1, DR2, and DR3.

According to some embodiments, the display panel DP may include the display surface DP-IS that is a flat type, however, the display surface DP-IS should not be limited to the flat type. The display panel DP may include a curved type display surface or a three-dimensional display surface. The three-dimensional display surface may include plural display areas that face different directions from each other.

Referring to FIG. 1B, the display panel DP may include a base layer BL, a circuit element layer DP-CL, and a light emitting element layer DP-OLED, and a colour conversion layer OSL. The base layer BL may include a synthetic resin substrate or a glass substrate. The circuit element layer DP-CL may include at least one insulating layer and a circuit element. The circuit element may include a signal line and a pixel driving circuit. The circuit element layer DP-CL may be formed by a process of forming an insulating layer, a semiconductor layer, and a conductive layer, such as coating and depositing processes, and a process of patterning the insulating layer, the semiconductor layer, and the conductive layer, such as a photolithography process. The light emitting element layer DP-OLED may include at least a light emitting element. The colour conversion layer OSL may convert a colour of a light provided from the light emitting element. The colour conversion layer OSL may include a light conversion pattern and a structure to improve a light conversion efficiency.

FIG. 1C shows an arrangement relationship between signal lines GL1 to GLn and DL1 to DLm and pixels PX11 to PXnm in a plan view. The signal lines GL1 to GLn and DL1 to DLm may include a plurality of gate lines GL1 to GLn and a plurality of data lines DL1 to DLm.

Each of the pixels PX11 to PXnm may be connected to a corresponding gate line among the gate lines GL1 to GLn and a corresponding data line among the data lines DL1 to DLm. Each of the pixels PX11 to PXnm may include the pixel driving circuit and the light emitting element. More types of signal lines may be provided in the display panel DP according to a configuration of the pixel driving circuit.

The pixels PX11 to PXnm may be arranged in a matrix form, however, the arrangement of the pixels PX11 to PXnm should not be limited to the matrix form. For instance, positions at which the pixels PX11 to PXnm are located may correspond to vertices of a diamond shape. A gate driving circuit GDC may be integrated in the display panel DP through an oxide silicon gate driver circuit (OSG) process or an amorphous silicon gate driver circuit (ASG) process.

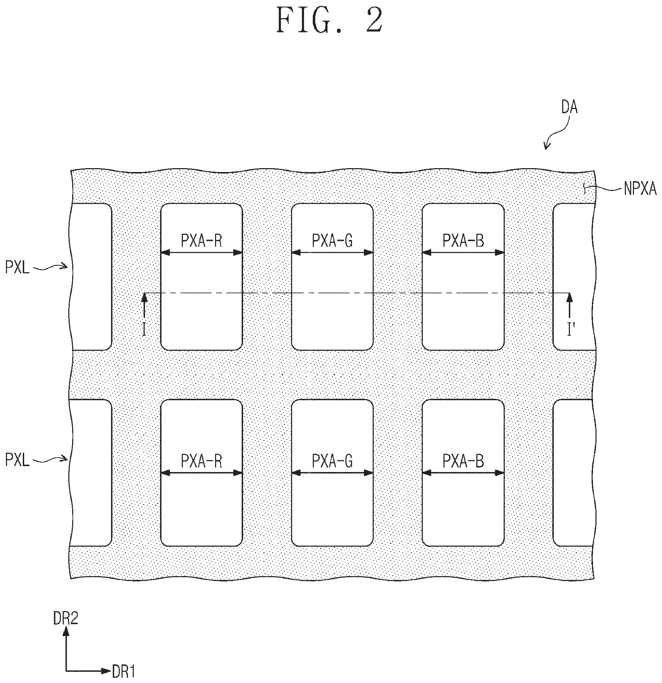

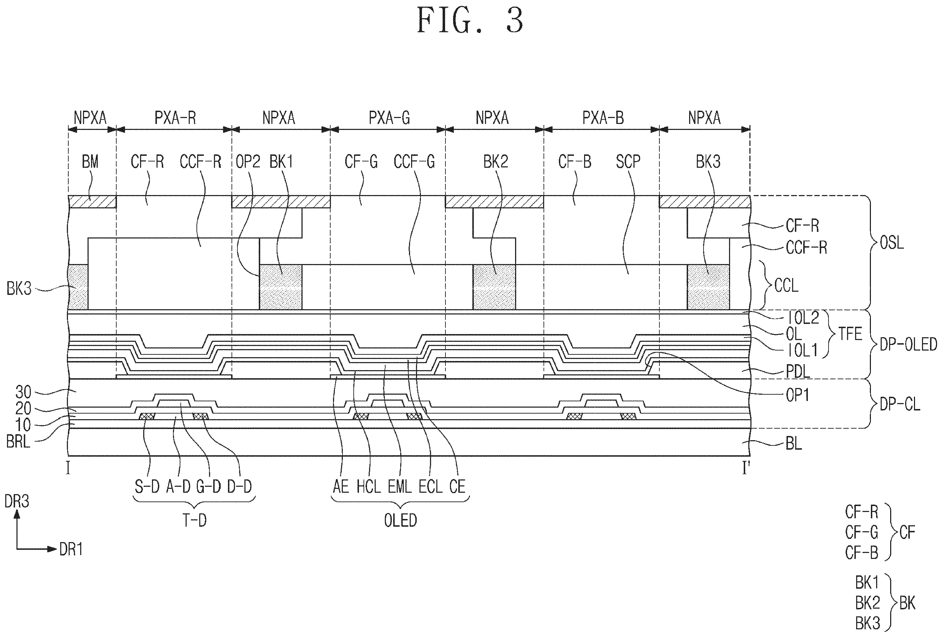

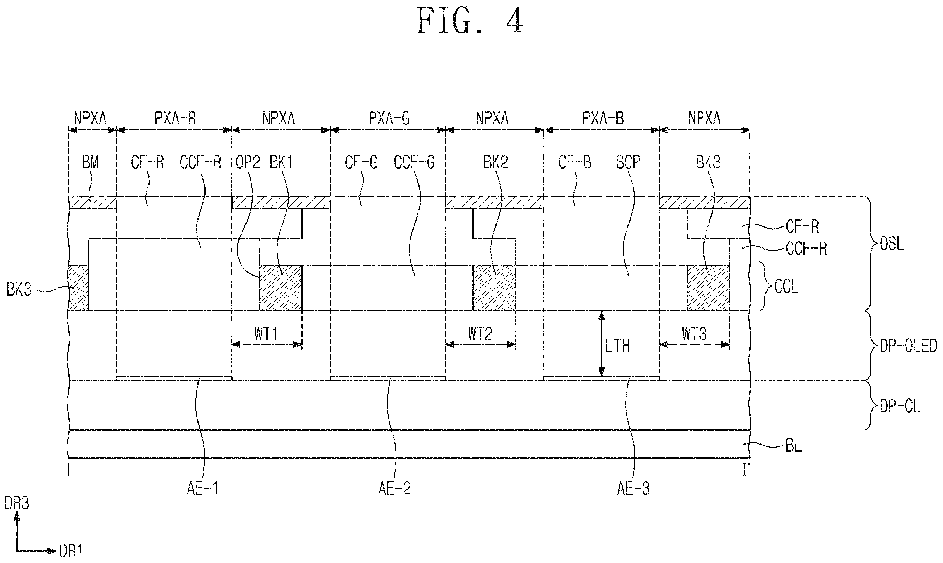

FIG. 2 is an enlarged plan view of the display panel DP according to some embodiments of the present disclosure. FIG. 3 is a cross-sectional view of the display panel DP according to some embodiments of the present disclosure. FIG. 4 is a cross-sectional view of a portion of the display panel DP according to some embodiments of the present disclosure.

FIG. 2 shows six pixel areas PXA-R, PXA-G, and PXA-B arranged in two pixel rows PXL as a representative example, although embodiments according to the present disclosure are not limited thereto, and in some embodiments, there may be additional pixels rows PXL according to the design of the display panel DP. FIG. 3 shows a cross-section taken along a line I-I' of FIG. 2. According to some embodiments, three pixel areas PXA-R, PXA-G, and PXA-B shown in FIG. 2 may be repeatedly arranged in the whole area of the display area DA (refer to FIG. 1A). A peripheral area NPXA may be defined around first, second, and third pixel areas PXA-R, PXA-G, and PXA-B. The peripheral area NPXA may define a boundary of the first, second, and third pixel areas PXA-R, PXA-G, and PXA-B, and a structure to prevent, reduce, or control a mixture of colours between the first, second, and third pixel areas PXA-R, PXA-G, and PXA-B may be located in the peripheral area NPXA.

According to some embodiments, the first, second, and third pixel areas PXA-R, PXA-G, and PXA-B may have the same size as each other when viewed in a plan view (e.g., when viewed from the direction DR3, or when viewed from a direction normal with respect to a plane of the display panel DP), however, they should not be limited thereto or thereby. Among the first, second, and third pixel areas PXA-R, PXA-G, and PXA-B, at least two pixel areas may have different sizes from each other. When viewed in a plan view, the first, second, and third pixel areas PXA-R, PXA-G, and PXA-B may have a rectangular shape with a rounded corner, however, they should not be limited thereto or thereby. From a plan view, the first, second, and third pixel areas PXA-R, PXA-G, and PXA-B may have other polygonal shapes, such as a rhombus shape, a pentagonal shape, etc.

One of the first, second, and third pixel areas PXA-R, PXA-G, and PXA-B may provide light of a first colour, also referred to as a first colour light corresponding to a source light, another of the first, second, and third pixel areas PXA-R, PXA-G, and PXA-B may provide a second colour light different from the first colour light, and the other of the first, second, and third pixel areas PXA-R, PXA-G, and PXA-B may provide a third colour light different from the first colour light and the second colour light. According to some embodiments, the first pixel area PXA-R may provide the first colour light, the second pixel area PXA-G may provide the second colour light, and the third pixel area PXA-B may provide the third colour light. According to some embodiments, the first colour light may be red light, the second colour light may be green light, and the third colour light may be blue light.

FIG. 3 is a cross-sectional view taken along the line I-I' of FIG. 2.

Referring to FIG. 3, the circuit element layer DP-CL may include a transistor T-D as its circuit element. The configuration of the circuit element layer DP-CL may be changed according to a design of the driving circuit of the pixel PX (refer to FIG. 1A), and FIG. 3 shows the transistor T-D as a representative example. An arrangement relationship between an active A-D, a source S-D, a drain D-D, and a gate G-D that form the transistor T-D is shown in FIG. 3. The active A-D, the source S-D, and the drain D-D may be distinguished from each other according to a doping concentration or a conductivity of a semiconductor pattern.

The circuit element layer DP-CL may include a lower buffer layer BRL, a first insulating layer 10, a second insulating layer 20, and a third insulating layer 30, which are located on the base layer BL. For instance, each of the lower buffer layer BRL, the first insulating layer 10, and the second insulating layer 20 may be an inorganic layer, and the third insulating layer 30 may be an organic layer.

The light emitting element layer DP-OLED may include a light emitting element OLED. The light emitting element OLED may generate the source light. The light emitting element OLED may include a first electrode AE, a second electrode CE, and a light emitting layer EML located between the first electrode AE and the second electrode CE. According to some embodiments, the light emitting element layer DP-OLED may include an organic light emitting diode as its light emitting element. According to some embodiments, the light emitting element OLED may include a quantum dot light emitting diode. That is, the light emitting layer EML included in the light emitting element OLED may include an organic light emitting material as its light emitting material, or the light emitting layer EML may include a quantum dot as its light emitting material. The quantum dot will be described in more detail later.

The light emitting element layer DP-OLED may include a pixel definition layer PDL. For instance, the pixel definition layer PDL may be an organic layer.

The first electrode AE may be located on the third insulating layer 30. The first electrode AE may be directly or indirectly connected to the transistor T-D. The pixel definition layer PDL may be provided with a first opening OP1 defined therethrough. At least a portion of the first electrode AE may be exposed through the first opening OP1 of the pixel definition layer PDL.

A hole control layer HCL, the light emitting layer EML, an electron control layer ECL may overlap at least the pixel area PXA-R. The hole control layer HCL, the light emitting layer EML, the electron control layer ECL, and the second electrode CE may be commonly arranged in the first, second, and third pixel areas PXA-R, PXA-G, and PXA-B (refer to FIG. 2). Each of the hole control layer HCL, the light emitting layer EML, the electron control layer ECL, and the second electrode CE, which overlaps the first, second, and third pixel areas PXA-R, PXA-G, and PXA-B, may have an integral shape, however, it should not be limited thereto or thereby. According to some embodiments, at least one of the hole control layer HCL, the light emitting layer EML, or the electron control layer ECL may be located in each of the first, second, and third pixel areas PXA-R, PXA-G, and PXA-B after being divided into plural portions.

The hole control layer HCL may include a hole transport layer and may further include a hole injection layer. The light emitting layer EML may generate the blue light as the source light. The blue light may have a wavelength from about 410 nm to about 480 nm. A light emission spectrum of the blue light may have a maximum peak within a wavelength range from about 440 nm to about 460 nm. The electron control layer ECL may include an electron transport layer and may further include an electron injection layer.

The light emitting element layer DP-OLED may include a thin film encapsulation layer TFE that protects the second electrode CE. The thin film encapsulation layer TFE may include an organic material or an inorganic material. The thin film encapsulation layer TFE may have a multi-layer structure in which an inorganic layer and an organic layer are repeatedly stacked. According to some embodiments, the thin film encapsulation layer TFE may have a structure of a first encapsulation inorganic layer IOL1/an encapsulation organic layer OL/a second encapsulation inorganic layer IOL2. The first and second encapsulation inorganic layers IOL1 and IOL2 may protect the light emitting element OLED from an external moisture, and the encapsulation organic layer OL may prevent or reduce instances of the light emitting element OLED getting scratches due to foreign substances or contaminants introduced during the manufacturing process. According to some embodiments, the display panel DP may further include a refractive-index control layer to improve a light emission efficiency.

As shown in FIG. 3, the colour conversion layer OSL may be located on the thin film encapsulation layer TFE. The colour conversion layer OSL may include a bank BK, colour conversion patterns CCF-R, CCF-G, and SCP, a light blocking pattern BM, and a colour filter CF.

The light blocking pattern BM may define the first pixel area PXA-R, the second pixel area PXA-G, and the third pixel area PXA-B. The light blocking pattern BM may be located in the peripheral area NPXA. The light blocking pattern BM may not overlap the first pixel area PXA-R, the second pixel area PXA-G, and the third pixel area PXA-B.

The bank BK may include a base resin and additives. The base resin may include various resin compositions that are generally referred to as a binder. The additives may include coupling agents and/or photoinitiators. The additives may further include a dispersant.

The bank BK may include a black colouring agent to block light. The bank BK may include a black dye or a black pigment mixed with the base resin. According to some embodiments, the black colouring agent may include a metal material, such as carbon black, chromium, or an oxide thereof. The bank BK may include a first bank BK1, a second bank BK2, and a third bank BK3. The first bank BK1 may be located between a first colour conversion pattern CCF-R and a second colour conversion pattern CCF-G, the second bank BK2 may be located between the second colour conversion pattern CCF-G and a third colour conversion pattern SCP, and the third bank may be located between the third colour conversion pattern SCP and the first colour conversion pattern CCF-R. The first bank BK1, the second bank BK2, and the third bank BK3 may have the same width in the first direction DR1.

The bank BK may define a second opening OP2 corresponding to the first opening OP1. When viewed in a plan view, the second opening OP2 may overlap the first opening OP1 and may have a size greater than that of the first opening OP1.

The colour conversion patterns CCF-R, CCF-G, and SCP may be located in the second opening OP2. The colour conversion patterns CCF-R, CCF-G, and SCP may convert optical properties of the source light. For example, some colour conversion patterns CCF-R and CCF-G of the colour conversion patterns CCF-R, CCF-G, and SCP may convert the optical properties of the source light. The colour conversion patterns CCF-R and CCF-G may include a quantum dot to convert the optical properties of the source light. The colour conversion patterns CCF-R, CCF-G, and SCP may include the first colour conversion pattern CCF-R overlapping the first pixel area PXA-R, the second colour conversion pattern CCF-G overlapping the second pixel area PXA-G, and the third colour conversion pattern SCP overlapping the third pixel area PXA-B. Meanwhile, the third colour conversion pattern SCP may be referred to as a transmission pattern.

The first colour conversion pattern CCF-R converts the first colour light that is the source light into the second colour light. The first colour light corresponds to the blue light, and the second colour light corresponds to the red light. The second colour conversion pattern CCF-G converts the blue light that is the source light into the green light. The green light corresponds to the third colour light. The transmission pattern SCP transmits the blue light that is the source light. Meanwhile, the blue light may have a wavelength from about 410 nm to about 480 nm. The red light may have a wavelength from about 620 nm to about 750 nm, and the green light may have a wavelength from about 500 nm to about 570 nm.

The first colour conversion pattern CCF-R and the second colour conversion pattern CCF-G may include the quantum dot and scattering particles, and the transmission pattern SCP may include only the scattering particles and may not include the quantum dot. The quantum dot included in the first colour conversion pattern CCF-R may be particles that convert the blue light that is the source light into the red light, and the quantum dot included in the second colour conversion pattern CCF-G may be particles that convert the blue light that is the source light into the green light.

According to some embodiments, the colour conversion patterns CCF-R, CCF-G, and SCP may be formed by an inkjet process. A liquid composition may be provided within the second opening OP2. The composition that is polymerized by a thermal curing process or a light curing process is reduced in volume after curing.

The colour filter CF may be located on the colour conversion layer OSL. The colour filter CF may transmit a light in a specific wavelength range and may block a light outside the specific wavelength range.

The colour filter CF may include a plurality of colour filters CF-R, CF-G, and CF-B. Each of the colour filters CF-R, CF-G, and CF-B may transmit the light in the specific wavelength range and may block the light outside the specific wavelength range. A first colour filter CF-R overlapping the first pixel area PXA-R may transmit the red light and may block the green light and the blue light. A second colour filter CF-G overlapping the second pixel area PXA-G may transmit the green light and may block the red light and the blue light. A third colour filter CF-B overlapping the third pixel area PXA-B may transmit the blue light and may block the green light and the red light. The colour filters CF-R, CF-G, and CF-B may include a base resin and a dye and/or a pigment dispersed in the base resin. The base resin may be a medium in which the dye and/or the pigment are dispersed and may include various resin compositions that are generally referred to as a binder.

Hereinafter, the quantum dots included in the colour conversion patterns CCF-R, CCF-G, and SCP will be described. The quantum dots may be particles that change a wavelength of a light incident thereto. The quantum dots are materials having a crystal structure of several nanometers in size, contain hundreds to thousands of atoms, and exhibit a quantum confinement effect in which an energy band gap increases due to a small size. When a light having a wavelength with an energy higher than the band gap is incident into the quantum dots, the quantum dots absorb the light and become excited, and then, the quantum dots emit a light of a specific wavelength and fall to the ground state. The emitted light of the specific wavelength has a value corresponding to the band gap. The light-emitting property of the quantum dots by the quantum confinement effect may be controlled by adjusting the size and the composition of the quantum dots.

The quantum dots may be selected from a group II-VI compound, a group III-V compound, a group I-III-VI compound, a group IV-VI compound, a group IV element, a group IV compound, and a combination thereof.

The group II-VI compound may be selected from a binary compound selected from the group consisting of CdSe, CdTe, ZnS, ZnSe, ZnTe, ZnO, HgS, HgSe, HgTe, MgSe, MgS, and a mixture thereof, a ternary compound selected from the group consisting of AgInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnS, and a mixture thereof.

The group I-III-VI compound may include a ternary compound selected from the group consisting of AgInS₂, CuInS₂, AgGaS₂, CuGaS₂, and a mixture thereof, or a quaternary compound of AgInGaS₂, CuInGaS₂, or the like.

The group III-V compound may be selected from a binary compound selected from the group consisting of GaN, GaP, GaAs, GaSb, AlN, AlP, AlAs, AlSb, InN, InP, InAs, InSb, and a mixture thereof, a ternary compound selected from the group consisting of GaNP, GaNAs, GaNSb, GaPAs, GaPSb, AlNP, AlNAs, AlNSb, AlPAs, AlPSb, InNP, InNAs, InNSb, InPAs, InPSb, GaAlNP, and a mixture thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. The group III-V compound may further include a group II metal. For instance, InZnP may be selected as a group III-II-V compound.

The group IV-VI compound may be selected from a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof. The group IV element may be selected from the group consisting of Si, Ge, and a mixture thereof. The group IV compound may be a binary compound selected from the group consisting of SiC, SiGe, and a mixture thereof.

In this case, the binary compound, the ternary compound, or the quaternary compound may exist in the particles at a uniform concentration or may exist in the same particle after being divided into plural portions having different concentrations.

Each quantum dot may have a core-shell structure that includes a core and a shell surrounding the core. In addition, the quantum dots may have a core/shell structure in which one quantum dot surrounds another quantum dot. An interface between the core and the shell may have a concentration gradient in which the concentration of elements existing in the shell is lowered as the distance from a center decreases.

The quantum dots may be nanometer-scale particles. The quantum dots may have a full width of half maximum (FWHM) of the light emission wavelength spectrum of about 45 nm or less, for example, about 40 nm or less, and for example, about 30 nm or less. A colour purity and a colour reproducibility may be improved within this range. In addition, because the light emitted through the quantum dots may be emitted in all directions, an optical viewing angle may be improved.

In addition, the shape of the quantum dots may be a shape commonly used in the art, and it should not be particularly limited. For example, spherical, pyramidal, multi-arm, or cubic nanoparticles, nanotubes, nanowires, nanofibers, nanoplatelets, or the like may be applied to the quantum dots. The quantum dots may control the colour of the emitted light according to the particle size, and accordingly, the converted light generated from the quantum dots may have various colours such as the red light, the green light, and the blue light.

FIG. 4 schematically shows a portion of the cross-section of FIG. 3. Referring to FIG. 4, a width (distance) between the first colour conversion pattern CCF-R and the second colour conversion pattern CCF-G, a width (distance) between the second colour conversion pattern CCF-G and the third colour conversion pattern SCP, and a width (distance) between the third colour conversion pattern SCP and the first colour conversion pattern CCF-R are different from each other.

A first width WT1 between the first colour conversion pattern CCF-R and the second colour conversion pattern CCF-G is the shortest distance on a straight line between a first electrode AE-1 corresponding to the first colour conversion pattern CCF-R and the second colour conversion pattern CCF-G adjacent to the first electrode AE-1 in the first direction DR1.

A second width WT2 between the second colour conversion pattern CCF-G and the third colour conversion pattern SCP is the shortest distance on a straight line between a first electrode AE-2 corresponding to the second colour conversion pattern CCF-G and the third colour conversion pattern SCP adjacent to the first electrode AE-2 in the first direction DR1.

A third width WT3 between the third colour conversion pattern SCP and the first colour conversion pattern CCF-R is the shortest distance on a straight line between a first electrode AE-3 corresponding to the third colour conversion pattern SCP and the first colour conversion pattern CCF-R adjacent to the first electrode AE-3 in the first direction DR1.

According to inventive embodiments, the first width WT1 between the first colour conversion pattern CCF-R and the second colour conversion pattern CCF-G is greater than the second width WT2 between the second colour conversion pattern CCF-G and the third colour conversion pattern SCP. The second width WT2 is greater than the third width WT3 between the third colour conversion pattern SCP and the first colour conversion pattern CCF-R.

That is, the third width WT3 has the smallest size among the first width WT1, the second width WT2, and the third width WT3.

A distance LTH in the third direction DR3 between the first, second, and third colour conversion patterns CCF-R, CCF-G, and SCP and the first electrodes AE-1, AE-2, and AE-3 respectively corresponding to the first, second, and third colour conversion patterns CCF-R, CCF-G, and SCP may be uniform. According to some embodiments, the third width WT3 may be greater than the distance LTH in the third direction DR3 between the third colour conversion pattern SCP and the first electrode AE-3 corresponding to the third colour conversion pattern SCP. As an example, the third width WT3 may be greater than 3 times the square root of the distance LTH in the third direction DR3 between the third colour conversion pattern SCP and the first electrode AE-3 corresponding to the third colour conversion pattern SCP.

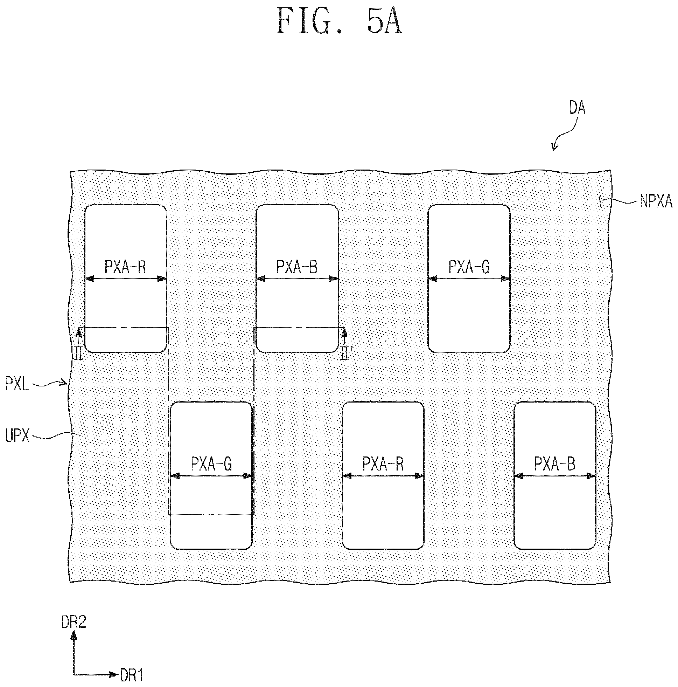

FIGS. 5A to 5C are enlarged plan views of display panels according to some embodiments of the present disclosure. FIGS. 5A to 5C show six pixel areas PXA-R, PXA-G, and PXA-B as a representative example, although embodiments according to the present disclosure are not limited thereto. The six pixel areas PXA-R, PXA-G, and PXA-B may be included in one unit pixel UPX. The unit pixel UPX may be repeatedly arranged in a display area DA (refer to FIG. 1A). A peripheral area NPXA may be defined around the first, second, and third pixel areas PXA-R, PXA-G, and PXA-B. A bank BK (refer to FIG. 3) may be located in the peripheral area NPXA to prevent mixture of colours between the first, second, and third pixel areas PXA-R, PXA-G, and PXA-B. In FIGS. 5A to 5C, the six pixel areas PXA-R, PXA-G, and PXA-B are arranged in an arrangement different from that of the six pixel areas of FIG. 2. Similar to the first, second, and third pixel areas PXA-R, PXA-G, and PXA-B of FIG. 2, the first, second, and third pixel areas PXA-R, PXA-G, and PXA-B shown in FIGS. 5A to 5C may have the same size as each other when viewed in a plan view, however, they should not be limited thereto or thereby. At least two pixel areas among the first, second, and third pixel areas PXA-R, PXA-G, and PXA-B may have different sizes from each other. The first, second, and third pixel areas PXA-R, PXA-G, and PXA-B may have a rectangular shape with a rounded corner, however, they should not be limited thereto or thereby. When viewed in a plan view, the first, second, and third pixel areas PXA-R, PXA-G, and PXA-B may have other polygonal shapes, such as a rhombus shape, a pentagonal shape, etc.

Referring to FIGS. 5A to 5C, at least one pixel area of the first pixel area PXA-R, the second pixel area PXA-G, and the third pixel area PXA-B may not be aligned with the other pixel areas of the first pixel area PXA-R, the second pixel area PXA-G, and the third pixel area PXA-B when viewed in a plan view. That is, the first pixel area PXA-R, the second pixel area PXA-G, and the third pixel area PXA-B may be arranged in the first direction DR1, at least one pixel area of the first pixel area PXA-R, the second pixel area PXA-G, and the third pixel area PXA-B may be arranged spaced apart from the other pixel areas of the first pixel area PXA-R, the second pixel area PXA-G, and the third pixel area PXA-B in the second direction DR2.

In FIG. 5A, the first pixel area PXA-R, the second pixel area PXA-G, and the third pixel area PXA-B may be arranged spaced apart from each other in one pixel row PXL along the first direction DR1 and the second direction DR2. Accordingly, a physical distance between the first pixel area PXA-R, the second pixel area PXA-G and the third pixel area PXA-B in a plan view may increase, and thus, the possibility of colour mixture may decrease.

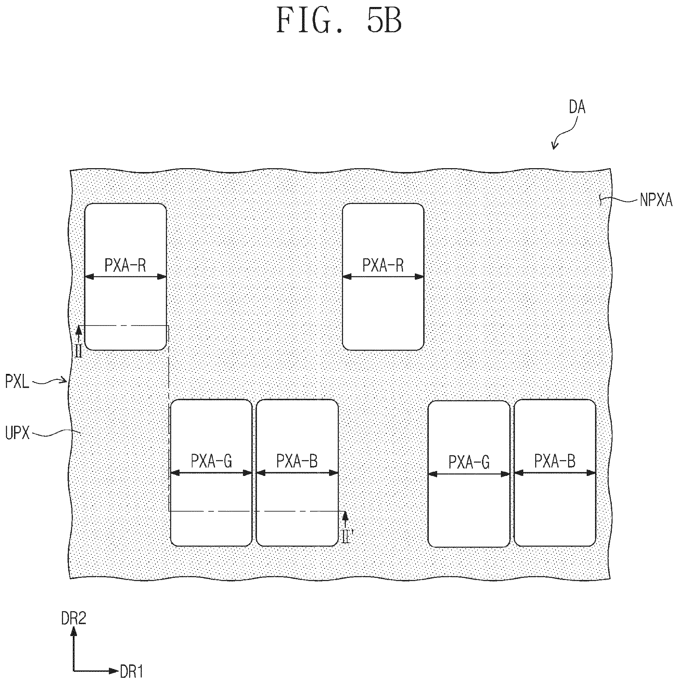

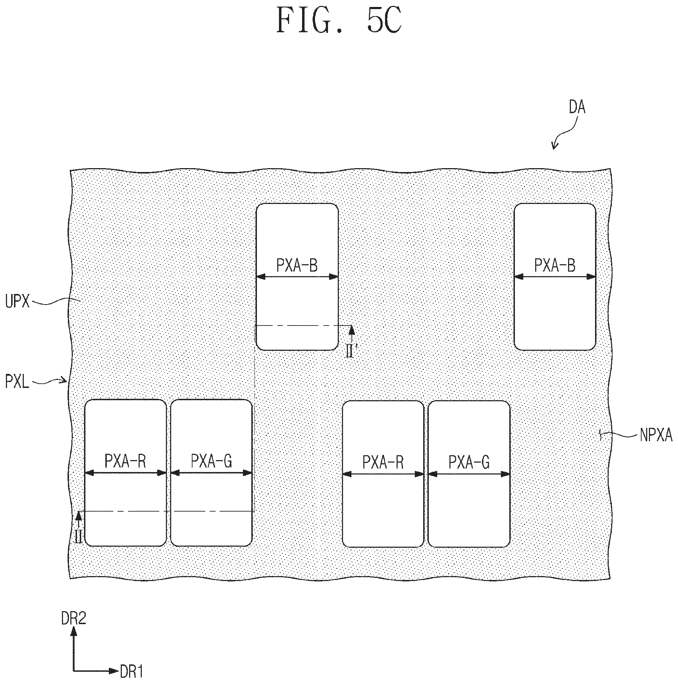

In some systems, the first pixel area PXA-R emitting red light is most affected by colour mixture compared with the second pixel area PXA-G emitting green light and the third pixel area PXA-B emitting blue light. In FIG. 5B, the first pixel area PXA-R may be spaced apart from the second pixel area PXA-G and the third pixel area PXA-B in the second direction DR2. Accordingly, a physical distance from the first pixel area PXA-R to the second and the third pixel areas PXA-G and PXA-B may increase, and thus, colour mixture between the first pixel area PXA-R, the second pixel area PXA-G, and the third pixel area PXA-B may be prevented or reduced. According to some embodiments, not only the first pixel area PXA-R but also the second pixel area PXA-G and/or the third pixel area PXA-B may be spaced apart from the other pixel areas in one pixel row PXL along the second direction DR2. As an example, in FIG. 5C, the third pixel area PXA-B may be arranged spaced apart from the first pixel area PXA-R and the second pixel area PXA-G in the second direction DR2.

According to some embodiments, the cross-sectional views of FIGS. 3 and 4 may be views showing cross-sections taken along the line I-I' of FIG. 2 and the line II-II' of FIGS. 5A to 5C. That is, according to some embodiments of the present disclosure, the first pixel area PXA-R, the second pixel area PXA-G, and the third pixel area PXA-B may not be aligned with each other when viewed in a plan view, and the widths between the first colour conversion pattern CCF-R, the second colour conversion pattern CCF-G, and the third colour conversion pattern SCP respectively corresponding to the first pixel area PXA-R, the second pixel area PXA-G, and the third pixel area PXA-B may be different from each other.

According to some embodiments, the first width WT1 (refer to FIG. 4) in the first direction DR1 between the first colour conversion pattern CCF-R overlapping the first pixel area PXA-R spaced apart from the second pixel area PXA-G and the third pixel area PXA-B in the second direction DR2 and the second colour conversion pattern CCF-G overlapping the second pixel area PXA-G may be equal to or greater than the second width WT2 (refer to FIG. 4) in the first direction DR1 between the second colour conversion pattern CCF-G and the third colour conversion pattern SCP. The third width WT3 between the third colour conversion pattern SCP and the first colour conversion pattern CCF-R may be smaller than the second width.

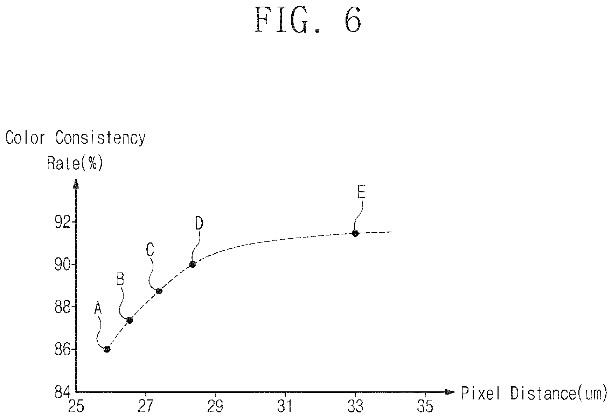

FIG. 6 is a graph showing an effect according to some embodiments of the present disclosure. A degree of decrease in colour consistency rate due to the colour mixture between the first, second, and third colour conversion patterns CCF-R, CCF-G, and SCP is the highest between the first colour conversion pattern CCF-R and the second colour conversion pattern CCF-G. Accordingly, the first width WT1 (refer to FIG. 4) between the first colour conversion pattern CCF-R and the second colour conversion pattern CCF-G may be greater than each of the second width WT2 (refer to FIG. 4) and the third width WT3 (refer to FIG. 4). In addition, an influence by the colour mixture between the second colour conversion pattern CCF-G and the third colour conversion pattern SCP may be greater than an influence by the colour mixture between the third colour conversion pattern SCP and the first colour conversion pattern CCF-R. Accordingly, the second width WT2 may be greater than the third width WT3.

The graph of FIG. 6 shows the colour consistency rate as a function of pixel distance. In this case, the pixel distance may be defined as any one of the above- described the first, second and third distance WT1, WT2 and WT3. In this case, the colour consistency rate may correspond to an index indicating the degree of colour mixture. It may mean that the colour mixture does not occur as the colour consistency rate is high.

In FIG. 6, as the pixel distance increases, the colour consistency rate increases. According to some embodiments, "A" may correspond to the third width WT3, "B" may correspond to the second width WT2, and "C" may correspond to the first width WT1. As an example, the first width WT1 may be about 28um, and in this case, the colour consistency rate may be about 89%. The second width WT2 may be about 27um, and in this case, the colour consistency rate may be about 87%. The third width WT3 may be about 26um, and in this case, the colour consistency rate may be about 86%.

Referring to FIG. 6, the colour consistency rate decreasing by the colour mixture may be compensated for by differently setting the first width WT1, the second width WT2, and the third width WT3.

Although some embodiments of the present invention have been described, it is understood that the invention should not be limited to these embodiments but various changes and modifications can be made by one of ordinary skill in the art within the scope of the claims.

## Claims

1. A display panel (DP) comprising:
a light emitting element layer (DP-OLED) comprising a plurality of light emitting elements (OLED) configured to emit blue light; and
a colour conversion layer (OSL) on the light emitting element layer that is configured to receive the blue light, the colour conversion layer comprising:
a first colour conversion pattern (CCF-R) corresponding to a first pixel area (PXA-R) that is configured to convert the wavelength of the blue light to output red light;
a second colour conversion pattern (CCF-G) corresponding to a second pixel area (PXA-G) that is configured to convert the wavelength of the blue light to output green light; and
a third colour conversion pattern (SCP) corresponding to a third pixel area (PXA-B) that is configured to transmit the blue light,
**characterized in that**:
a first distance (WT1), which is the shortest distance on a straight line between the first electrode (AE-1) corresponding to the first colour conversion pattern (CCF-R) and the second colour conversion pattern (CCF-G) adjacent to the first electrode (AE-1) corresponding to the first colour conversion pattern (CCF-R) in a first direction (DR1), wherein the first direction is parallel to the surface of the display panel,
a second distance (WT2), which is the shortest distance on a straight line between the first electrode (AE-2) corresponding to the second colour conversion pattern (CCF-G) and the third colour conversion pattern (SCP) adjacent to the first electrode (AE-2) corresponding to the second colour conversion pattern (CCF-G) in the first direction (DR1),
and a third distance (WT3), which is the shortest distance on a straight line between the first electrode (AE-3) corresponding to the third colour conversion pattern (SCP) and the first colour conversion pattern (CCF-R) adjacent to the first electrode corresponding to the third colour conversion pattern (SCP) in the first direction,
are different from each other,
wherein the first distance (WT₁) is greater than the second distance (WT₂) , and the second distance (WT₂) is greater than the third distance (WT₃)

2. The display panel of claim 1, wherein each of the light emitting elements comprises:
a first electrode (AE);
a light emitting layer (EML) on the first electrode; and
a second electrode (CE) on the light emitting layer, and the light emitting element layer further comprises a pixel definition layer (PDL) provided with an opening (OP1) through which at least a portion of the first electrode (AE) is exposed.

3. The display panel of claim 2, wherein the light emitting element layer further comprises a thin film encapsulation layer (TFE) protecting the second electrode (CE), and the colour conversion layer (OSL) is on the thin film encapsulation layer.

4. The display panel of claim 2 or 3, wherein each of the light emitting elements further comprises at least one of a hole control layer (ECL) or an electron control layer (ECL), which overlaps at least the light emitting layer (EML), and a portion of at least one of the hole control layer or the electron control layer is between the pixel definition layer (PDL) and the colour conversion layer.

5. The display panel of any one of the preceding claims, wherein the colour conversion layer (OSL) further comprises a colour filter (CF) configured to transmit the red light and the green light.

6. The display panel of claim 5, wherein the colour filter comprises:
a first colour filter (CF-R) overlapping the first colour conversion pattern;
a second colour filter (CF-G) overlapping the second colour conversion pattern; and
a third colour filter (CF-B) overlapping the third colour conversion pattern.

7. The display panel of claim 2, wherein the colour conversion layer (OSL) further comprises:
a first bank (BK1) between the first colour conversion pattern (CCF-R) and the second colour conversion pattern (CCF-G);
a second bank (BK2) between the second colour conversion pattern (CCF-G) and the third colour conversion pattern (SCP); and
a third bank (BK3) between the third colour conversion pattern (SCP) and the first colour conversion pattern (CCF-R).

8. The display panel of claim 1, wherein the third distance (WT3) is greater than a distance in a direction (DR2) perpendicular to the first direction between the third colour conversion pattern and the first electrode corresponding to the third colour conversion pattern.

9. The display panel of claim 7, wherein the first bank (BNK1), the second bank (BNK2), and the third bank (BNK3) have the same width in the first direction.

10. The display panel of claim 9, wherein at least one pixel area of the first pixel area, the second pixel area, and the third pixel area is not aligned with the other pixel areas from among the first pixel area, the second pixel area, and the third pixel area in a plan view.

## Patentansprüche

1. Anzeigetafel (DP), umfassend:
eine Schicht eines lichtemittierenden Elements (DP-OLED), die eine Vielzahl von lichtemittierenden Elementen (OLED) umfasst, die dazu konfiguriert ist, blaues Licht zu emittieren; und
eine Farbumwandlungsschicht (OSL) auf der Schicht des lichtemittierenden Elements, die dazu konfiguriert ist, das blaue Licht zu empfangen, wobei die Farbumwandlungsschicht Folgendes umfasst:
ein erstes Farbumwandlungsmuster (CCF-R) entsprechend einem ersten Pixelbereich (PXA-R), das dazu konfiguriert ist, die Wellenlänge des blauen Lichts umzuwandeln, um rotes Licht auszugeben;
ein zweites Farbumwandlungsmuster (CCF-G) entsprechend einem zweiten Pixelbereich (PXA-G), das dazu konfiguriert ist, die Wellenlänge des blauen Lichts umzuwandeln, um grünes Licht auszugeben; und
ein drittes Farbumwandlungsmuster (SCP) entsprechend einem dritten Pixelbereich (PXA-B), das dazu konfiguriert ist, das blaue Licht durchzulassen,
**dadurch gekennzeichnet, dass**:
sich ein erster Abstand (WT1), welcher der kürzeste Abstand auf einer geraden Linie zwischen der ersten Elektrode (AE-1) entsprechend dem ersten Farbumwandlungsmuster (CCF-R) und dem zweiten Farbumwandlungsmuster (CCF-G) benachbart zu der ersten Elektrode (AE-1) entsprechend dem ersten Farbumwandlungsmuster (CCF-R) in einer ersten Richtung (DR1) ist, wobei die erste Richtung parallel zu der Oberfläche der Anzeigetafel ist,
ein zweiter Abstand (WT2), welcher der kürzeste Abstand auf einer geraden Linie zwischen der ersten Elektrode (AE-2) entsprechend dem zweiten Farbumwandlungsmuster (CCF-G) und dem dritten Farbumwandlungsmuster (SCP) benachbart zu der ersten Elektrode (AE-2) entsprechend dem zweiten Farbumwandlungsmuster (CCF-G) in der ersten Richtung (DR1) ist,
und ein dritter Abstand (WT3), welcher der kürzeste Abstand auf einer geraden Linie zwischen der ersten Elektrode (AE-3) entsprechend dem dritten Farbumwandlungsmuster (SCP) und dem ersten Farbumwandlungsmuster (CCF-R) benachbart zu der ersten Elektrode entsprechend dem dritten Farbumwandlungsmuster (SCP) in der ersten Richtung ist,
voneinander unterscheiden,
wobei der erste Abstand (WT1) größer als der zweite Abstand (WT₂) ist und der zweite Abstand (WT₂) größer als der dritte Abstand (WT₃) ist.

2. Anzeigetafel nach Anspruch 1, wobei jedes der lichtemittierenden Elemente Folgendes umfasst:
eine erste Elektrode (AE);
eine lichtemittierende Schicht (EML) auf der ersten Elektrode; und
eine zweite Elektrode (CE) auf der lichtemittierenden Schicht, und die Schicht des lichtemittierenden Elements ferner eine Pixeldefinitionsschicht (PDL) umfasst, die mit einer Öffnung (OP1) bereitgestellt ist, durch die zumindest ein Abschnitt der ersten Elektrode (AE) freigelegt ist.

3. Anzeigetafel nach Anspruch 2, wobei die Schicht des lichtemittierenden Elements ferner eine Dünnfilmverkapselungsschicht (TFE) umfasst, welche die zweite Elektrode (CE) schützt, und wobei die Farbumwandlungsschicht (OSL) auf der Dünnfilmverkapselungsschicht ist.

4. Anzeigetafel nach Anspruch 2 oder 3, wobei jedes der lichtemittierenden Elemente ferner zumindest eines von einer Lochsteuerschicht (ECL) oder einer Elektronensteuerschicht (ECL), die zumindest die lichtemittierende Schicht (EML) überlappt, umfasst, und ein Abschnitt von zumindest einem von der Lochsteuerschicht oder der Elektronensteuerschicht zwischen der Pixeldefinitionsschicht (PDL) und der Farbumwandlungsschicht ist.

5. Anzeigetafel nach einem der vorhergehenden Ansprüche, wobei die Farbumwandlungsschicht (OSL) ferner einen Farbfilter (CF) umfasst, der dazu konfiguriert ist, das rote Licht und das grüne Licht durchzulassen.

6. Anzeigetafel nach Anspruch 5, wobei der Farbfilter Folgendes umfasst:
einen ersten Farbfilter (CF-R), der das erste Farbumwandlungsmuster überlappt;
einen zweiten Farbfilter (CF-G), der das zweite Farbumwandlungsmuster überlappt; und
einen dritten Farbfilter (CF-B), der das dritte Farbumwandlungsmuster überlappt.

7. Anzeigetafel nach Anspruch 2, wobei die Farbumwandlungsschicht (OSL) ferner Folgendes umfasst:
eine erste Bank (BK1) zwischen dem ersten Farbumwandlungsmuster (CCF-R) und dem zweiten Farbumwandlungsmuster (CCF-G);
eine zweite Bank (BK2) zwischen dem zweiten Farbumwandlungsmuster (CCF-G) und dem dritten Farbumwandlungsmuster (SCP); und
eine dritte Bank (BK3) zwischen dem dritten Farbumwandlungsmuster (SCP) und dem ersten Farbumwandlungsmuster (CCF-R).

8. Anzeigetafel nach Anspruch 1, wobei der dritte Abstand (WT3) größer als ein Abstand in einer Richtung (DR2) senkrecht zu der ersten Richtung zwischen dem dritten Farbumwandlungsmuster und der ersten Elektrode entsprechend dem dritten Farbumwandlungsmuster ist.

9. Anzeigetafel nach Anspruch 7, wobei die erste Bank (BNK1), die zweite Bank (BNK2) und die dritte Bank (BNK3) die gleiche Breite in der ersten Richtung aufweisen.

10. Anzeigetafel nach Anspruch 9, wobei zumindest ein Pixelbereich des ersten Pixelbereichs, des zweiten Pixelbereichs und des dritten Pixelbereichs in einer Draufsicht nicht mit den anderen Pixelbereichen aus dem ersten Pixelbereich, dem zweiten Pixelbereich und dem dritten Pixelbereich ausgerichtet ist.

## Revendications

1. Panneau d'affichage (DP) comprenant :
une couche d'éléments électroluminescents (DP-OLED) comprenant une pluralité d'éléments électroluminescents (OLED) configurés pour émettre de la lumière bleue ; et
une couche de conversion de couleur (OSL) sur la couche d'éléments électroluminescents, qui est configurée pour recevoir la lumière bleue, la couche de conversion de couleur comprenant :
un premier motif de conversion de couleur (CCF-R) correspondant à une première zone de pixels (PXA-R), qui est configuré pour convertir la longueur d'onde de la lumière bleue pour délivrer en sortie de la lumière rouge ;
un deuxième motif de conversion de couleur (CCF-G) correspondant à une deuxième zone de pixels (PXA-G), qui est configuré pour convertir la longueur d'onde de la lumière bleue pour délivrer en sortie de la lumière verte ; et
un troisième motif de conversion de couleur (SCP) correspondant à une troisième zone de pixels (PXA-B), qui est configuré pour émettre la lumière bleue, **caractérisé en ce que** :
une première distance (WT1), qui est la distance la plus courte sur une ligne droite entre la première électrode (AE-1) correspondant au premier motif de conversion de couleur (CCF-R) et le deuxième motif de conversion de couleur (CCF-G) adjacent à la première électrode (AE-1) correspondant au premier motif de conversion de couleur (CCF-R) dans une première direction (DR1), ladite première direction étant parallèle à la surface du panneau d'affichage,
une deuxième distance (WT2), qui est la distance la plus courte sur une ligne droite entre la première électrode (AE-2) correspondant au deuxième motif de conversion de couleur (CCF-G) et le troisième motif de conversion de couleur (SCP) adjacent à la première électrode (AE-2) correspondant au deuxième motif de conversion de couleur (CCF-G) dans la première direction (DR1),
et une troisième distance (WT3), qui est la distance la plus courte sur une ligne droite entre la première électrode (AE-3) correspondant au troisième motif de conversion de couleur (SCP) et le premier motif de conversion de couleur (CCF-R) adjacent à la première électrode correspondant au troisième motif de conversion de couleur (SCP) dans la première direction,
sont différentes les unes des autres,
ladite première distance (WT1) étant supérieure à ladite deuxième distance (WT₂) et ladite deuxième distance (WT₂) étant supérieure à ladite troisième distance (WT₃).

2. Panneau d'affichage selon la revendication 1, chacun desdits éléments électroluminescents comprenant :
une première électrode (AE) ;
une couche électroluminescente (EML) sur la première électrode ; et
une seconde électrode (CE) sur la couche électroluminescente, et la couche d'éléments électroluminescents comprenant en outre une couche de définition de pixels (PDL) munie d'une ouverture (OP1) à travers laquelle au moins une partie de la première électrode (AE) est exposée.

3. Panneau d'affichage selon la revendication 2, ladite couche d'éléments électroluminescents comprenant en outre une couche d'encapsulation en couches minces (TFE) protégeant la seconde électrode (CE), et ladite couche de conversion de couleur (OSL) se trouvant sur la couche d'encapsulation en couches minces.

4. Panneau d'affichage selon la revendication 2 ou 3, chacun desdits éléments électroluminescents comprenant en outre au moins une parmi une couche de commande de trous (ECL) ou une couche de commande d'électrons (ECL), qui chevauche au moins la couche électroluminescente (EML), et une partie d'au moins une parmi la couche de commande de trous ou la couche de commande d'électrons se trouvant entre la couche de définition de pixels (PDL) et la couche de conversion de couleur.

5. Panneau d'affichage selon l'une quelconque des revendications précédentes, ladite couche de conversion de couleur (OSL) comprenant en outre un filtre de couleur (CF) configuré pour émettre la lumière rouge et la lumière verte.

6. Panneau d'affichage selon la revendication 5, ledit filtre de couleur comprenant :
un premier filtre de couleur (CF-R) chevauchant le premier motif de conversion de couleur ;
un deuxième filtre de couleur (CF-G) chevauchant le deuxième motif de conversion de couleur ; et
un troisième filtre de couleur (CF-B) chevauchant le troisième motif de conversion de couleur.

7. Panneau d'affichage selon la revendication 2, ladite couche de conversion de couleur (OSL) comprenant en outre :
un premier banc (BK1) entre le premier motif de conversion de couleur (CCF-R) et le deuxième motif de conversion de couleur (CCF-G) ;
un deuxième banc (BK2) entre le deuxième motif de conversion de couleur (CCF-G) et le troisième motif de conversion de couleur (SCP) ; et
un troisième banc (BK3) entre le troisième motif de conversion de couleur (SCP) et le premier motif de conversion de couleur (CCF-R).

8. Panneau d'affichage selon la revendication 1, ladite troisième distance (WT3) étant supérieure à une distance dans une direction (DR2) perpendiculaire à la première direction entre le troisième motif de conversion de couleur et la première électrode correspondant au troisième motif de conversion de couleur.

9. Panneau d'affichage selon la revendication 7, ledit premier banc (BNK1), ledit deuxième banc (BNK2) et ledit troisième banc (BNK3) ayant la même largeur dans la première direction.

10. Panneau d'affichage selon la revendication 9, au moins une zone de pixels parmi la première zone de pixels, la deuxième zone de pixels et la troisième zone de pixels n'étant pas alignée avec les autres zones de pixels parmi la première zone de pixels, la deuxième zone de pixels et la troisième zone de pixels dans une vue en plan.
